**Europäisches Patentamt**

**European Patent Office**

**Office européen des brevets**

(19)

(11) Veröffentlichungsnummer: **0 012 828**

**A1**

(12) # EUROPÄISCHE PATENTANMELDUNG

(21) Anmeldenummer: **79104461.3**

(22) Anmeldetag: **12.11.79**

(51) Int. Cl.³: **G 06 F 11/10**

(30) Priorität: **22.12.78 DE 2855807**

(43) Veröffentlichungstag der Anmeldung:
**09.07.80 Patentblatt 80/14**

(84) Benannte Vertragsstaaten:
**FR GB NL**

(71) Anmelder: **SIEMENS AKTIENGESELLSCHAFT Berlin und München**
**Postfach 22 02 61**
**D-8000 München 22(DE)**

(72) Erfinder: **Kaiserswerth, Rudolf, Dipl.-Ing.**
**Leitzachstrasse 6**
**D-8000 München 90(DE)**

(54) **Schaltungsanordnung zur Korrektur von bytestrukturierten Fehlern.**

(57) In einer Korrektureinrichtung zur Korrektur von bytestrukturierten Fehlern wird ein GMC-Code benützt. Die Fehlersyndrome werden zum Zweck der Decodierung bereichsweise in zwei Teilsyndrome zerlegt, welche als Elemente $\alpha^i$ von Galoisfeldern $GF(2^r)$ aufgefaßt werden können. Die Bits der Teilsyndrome dienen zur Adressierung von je zwei Festwertspeichern, die die Exponenten i der Koeffizienten $\alpha^i$ enthalten. Die Differenz modulo $2^r-1$ aus den aufgrund eines bestimmten Fehlersyndroms aus den Festwertspeichern gelesenen Inhalten gibt unmittelbar den Ort des fehlerhaften Bytes in rein binärer Verschlüsselung an.

./...

Croydon Printing Company Ltd.

FIG1

SIEMENS AKTIENGESELLSCHAFT    . Unser Zeichen
Berlin und München                 VPA 78 P 2080 ·EUR

Schaltungsanordnung zur Korrektur von bytestrukturierten
Fehlern.

Die Erfindung bezieht sich auf eine Schaltungsanordnung
·gemäß dem Oberbegriff·des Patentanspruchs 1.

In Einrichtungen zur Behandlung digitaler Daten, wie beispielsweise Datenverarbeitungs- und Fernsprechvermittlungsanlagen oder Datenübertragungseinrichtungen werden zur Erhöhung der Verarbeitungs- bzw. Übertragungsgeschwindigkeit
zunehmend größere  Datenmengen parallel übertragen. Bei
dem üblichen Aufbau solcher Einrichtungen aus integrierten
Bausteinen werden $b$ Bits umfassende Datengruppen, die im
folgenden Bytes genannt werden, über jeweils einen Baustein
geleitet, so daß der Totalausfall eines Bausteins sogenannte
bytestrukturierte Fehler erzeugt. Eine spezielle Klasse
von Codes zur Korrektur solcher Fehler ist bereits aus
"IEEE Transactions on Computers", Vol.C-21, Nr. 12, Dez.
1972, Seiten 1322 bis 1331, unter der Bezeichnung GMC-
Codes bekannt. Diese Codes sind bei einer vorgegebenen
Bytelänge zu je $b$ Bits mit einer davon abhängigen Anzahl
von Prüfbits $k = yb + z$ mit $y \geq 2$ und $0 \leq z < b$, wobei alle Größen
ganze Zahlen sind, in der Lage, jede mögliche Anzahl von
gefälschten Bits innerhalb eines Bytes zu korrigieren. Nach Vorgabe der Anzahl der Prüfbits lassen sich unter Berücksichtigung der einschränkenden Bedingungen die Werte für y und z festlegen. Daraus ergibt sich die gesamte Codelänge in Bits

$$n = b \; \frac{2^k - 1 - 2^b(2^z - 1)}{2^b - 1} + z$$

und somit schließlich die Anzahl der zu sichernden Datenbits zu m=n-k.

Ein GMC-Code ermöglicht zwar, wie angegeben, die Korrektur eines vollständig gefälschten Bytes, aber er läßt die Erkennung von Fehlern, die mehr als ein Byte betreffen, nicht zu. Ein solcher Code wird als perfekter Code bezeichnet. Dies gilt allerdings nur für einen unverkürzten GMC-Code, bei dem die maximale Anzahl von zu sichernden Datenbits auch wirklich benutzt wird. Bei einem verkürzten GMC-Code werden gewisse Mehrfachfehler erkennbar.

Die Decodierung von Fehlersyndromen auf der Grundlage eines GMC-Codes mit Hilfe von Schieberegistern ist aus der vorstehend genannten Literaturstelle ebenfalls bekannt. Diese Lösung erfordert nur einen sehr geringen Schaltungsaufwand. Dafür ist aber der Zeitbedarf für die Decodierung des Syndroms sehr hoch, so daß diese Lösung für den Einsatz vor allem in modernen Datenverarbeitungsanlagen nicht in Frage kommt. Der Erfindung liegt daher die Aufgabe zugrunde, eine Schaltungsanordnung zur Korrektur von bytestrukturierten Fehlern unter Verwendung eines GMC-Codes anzugeben, die gleichfalls nur einen geringen Schaltungsaufwand benötigt, aber das Decodierungsergebnis in wesentlich kürzerer Zeit als die bekannte Schaltungsanordnung liefert. Gemäß der Erfindung wird diese Aufgabe mit Hilfe der Merkmale im kennzeichnenden Teil des Patentanspruchs 1 gelöst.

Im folgenden wird die Erfindung anhand von Ausführungsbei-

.0012828

spielen unter Zuhilfenahme der Zeichnung näher beschrieben. Es zeigt

Fig. 1 ein Ausführungsbeispiel einer Fehlerkorrektureinrichtung in allgemeiner Form,

Fig. 2 und 3 Ausführungsbeispiele der Subtrahiereinrichtung nach Fig. 1,

Fig. 4 ein Korrekturnetzwerk für ein Byte,

Fig. 5 die $H_s$-Matrix eines GMC$(42,36)^2$-Codes

Fig. 6 ein spezielles Ausführungsbeispiel der Fehlerkorrektureinrichtung,

Fig. 7a bis 7d die Belegung der Festwertspeicher nach Fig. 6,

Fig. 8 Zusatzschaltungen bei der Verwendung eines verkürzten GMC-Codes.

Für die Festlegung der Parameter eines GMC-Korrekturcodes, wie Anzahl b der Bits je Byte, Anzahl k der Prüfbzw. Syndrombits, Anzahl m der zu sichernden Datenbits und Codelänge n in Bits, gelten die schon eingangs angegebenen Beziehungen.

(1) $k = yb + z$ mit $y \geq 2$ und $0 \leq z < b$ sowie

(2) $m = b \dfrac{2^k - 1 - 2^b(2^z - 1)}{2^b - 1} + z - k.$

Dabei sind alle Größen ganze Zahlen.

Im allgemeinen sind die Bytelänge und die Mindestanzahl der zu sichernden Datenbits vorgegeben. Man kann nun beispielsweise zunächst k=2b mit (y=2, z=0) setzen und prüfen, ob m die gewünschte Größe erreicht. Solange das nicht der Fall ist, wird k jeweils um 1 erhöht. Wenn alle Parameter vorliegen, läßt sich die systematische $H_s$-Materix erstellen. Die $H_s$-Matrix gibt bekanntlich eine anschauliche Darstellung eines Korrekturcodes und bezeichnet diejenigen Datenbits, die bei der Ableitung der Prüfbits durch zeilenweise modulo-2-Addition zu berücksichtigen sind. Darüber hinaus ist aus den Spalten der $H_s$-Matrix

unmittelbar das Fehlersyndrom für ein gefälschtes Bit abzulesen.

In allgemeiner Form hat die $H_s$-Matrix folgende Struktur

| $H_s =$ | $E_k$ | $H_{(k,b)}$ | O-Matrix $H_{(k-b,b)}$ | O-Matrix | | O-Matrix $H_{(2b+z,b)}$ |
|---|---|---|---|---|---|---|
| | | j=0 | j=1 | | | j=y-2 |

Die $H_s$-Matrix des GMC-Codes besteht aus einer k·k Einheitsmatrix $E_k$, die den Prüfbits zugeordnet ist und mehreren
Datenbereichen j=0...(y-2). Die einzelnen Datenbitbereiche
$B_j$ werden durch eine Null-Matrix mit jb Zeilen, die sich
über den ganzen Datenbitbereich erstrecken, und durch eine
Teilmatrix $H_{(k-jb,b)}$ gebildet. Für den Datenbitbereich $B_0$
verschwindet somit die Null-Matrix.

Die Länge der einzelnen Teilmatrizen bzw. Bereiche ergibt
sich zu b$(2^{r_j}-1)$ Bits mit $r_j=k-(j+1)b$. Jede Teilmatrix
hat die folgende Struktur

| $\alpha^0 \ \alpha^1 ... \alpha^{b-1}$ | $\alpha^0 \ \alpha^1 ... \alpha^{b-1}$ | ... | $\alpha^0 \ \alpha^1 \ ... \alpha^{b-1}$ | $\rightarrow S_h$ |
|---|---|---|---|---|
| $\alpha^0 \ \alpha^1 ... \alpha^{b-1}$ | $\alpha^1 \ \alpha^2 ... \alpha^b$ | | $\alpha^i \ \alpha^{i+1} ... \alpha^{i+b-1}$ | $\rightarrow S_1$ |
| Byte 0 | Byte 1 | | Byte i | |

Alle Elemente stammen aus dem Galoisfeld $GF(2^{r_j})$ bzw.
$GF(2^{k-(j+1)b})$. Jeder Abschnitt einer Teilmatrix weist b
Spalten auf und umfaßt daher ein Byte. Es wurde schon
darauf hingewiesen, daß sich aus jeder Spalte der $H_s$-Ma-
trix unmittelbar das Fehlersyndrom für ein gefälschtes
Bit ablesen läßt. Das Fehlersyndrom für mehrere oder alle
Bytes ergibt sich durch Überlagerung modulo-2 der Einzelfehlersyndrome. Da die gegebenenfalls zugeordneten O-Matrizen keine Beiträge zu den Fehlersyndromen liefern, gilt
dies auch für die Teilmatrizen. Ein spaltenweiser Vergleich

der Exponenten von $\alpha$ in der vorstehend angegebenen Grundstruktur einer Teilmatrix zeigt nun, daß die Exponenten
sich abschnittsweise, d. h. byteweise um Beträge unterscheiden, die der Bytenummer bei einer mit Null beginnenden Zählung entsprechen. Mit anderen Worten bedeutet das,
daß die Differenz der Exponenten unmittelbar das Byte bezeichnet, das insgesamt gefälscht wurde oder gefälschte
Bits enthält.

Diese Eigenschaft der GMC-Codes wird bei der Schaltungsanordnung gemäß der Erfindung zur Decodierung der Fehlersyndrome ausgenützt. Zu diesem Zweck werden innerhalb einer jeden Teilmatrix die b aus der oberen Zeile der zugeordneten Grundstruktur abgeleiteten Syndrombits formal zu
einem oberen Teilsyndrom $S_n$ und die restlichen $k-(j+1)b$
aus der unteren Zeile abgeleiteten Syndrombits zu einem
unteren Teilsyndrom $S_l$ zusammengefaßt.
Daraus ergibt sich

$$\frac{S_l}{S_n} = \frac{\alpha^p}{\alpha^q} = \frac{\alpha^i \cdot \alpha^q}{\alpha^q} = \alpha^{(i+q)-q} = \alpha^i$$

Für die Bestimmung des Orts des fehlerhaften Bytes sind
drei Schritte notwendig:
a) Umsetzen der Koeffizientenschreibweise $\alpha^p$ und $\alpha^q$ in
den Teilmatrizen in die Exponentendarstellung,
b) Errechnen der Exponentendifferenz als binäre Zahl,
c) Bildung von Fehlerortsignalen.

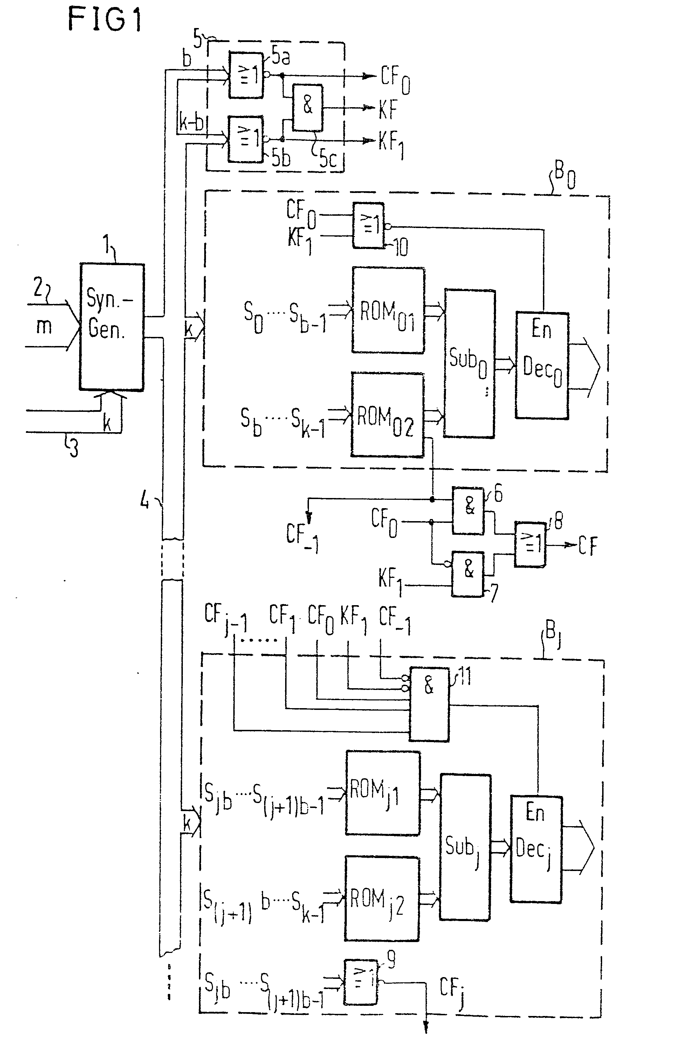

In Fig. 1 ist eine Schaltungsanordnung zur Fehlerkorrektur als Blockschaltbild vereinfacht dargestellt. Ein Syndromgenerator 1 empfängt von einer nicht dargestellten
Sendestelle mit einer Einrichtung zur Ableitung von Prüfbits über ein Leitungsbündel 2 m Datenbits und über ein
weiteres Leitungsbündel 3 k Prüfbits $C_0$ bis $C_{k-1}$. Solche
Einrichtungen bestehen zumeist aus EXKLUSIV-ODER-Gliedern
und sind allgemein bekannt. Der Syndromgenerator 1 vergleicht die empfangenen Prüfbits mit den neuerdings aus
den Datenbits abgeleiteten Prüfbits. Das Ergebnis des Vergleichs ist das über das Leitungsbündel 4 ausgegebene Syndrom mit k Bits $s_0$ bis $s_{k-1}$.

Das Syndrom wird in einem ersten Nulldetektor 5 überprüft,
ob sein Wert Null ist, d. h. ob alle Syndrombits $s_0$ bis
$s_{k-1}$ gleich Null sind. Hierzu werden die ersten b Syndrombits $s_0$ bis $s_{b-1}$ einem ersten NOR-Glied 5a und die restlichen k-b Syndrombits $s_b$-$s_{k-1}$ einem zweiten NOR-Glied 5b
zugeführt. Die Ausgangssignale $CF_0$ und $KF_1$ werden durch
ein UND-Glied 5c zu einem Signal KF zusammengefaßt, dessen
logischer Wert 1 besagt, daß kein Fehler aufgetreten ist.
Es erfolgt die sofortige Datenfreigabe.

Die Decodierung eines von Null verschiedenen Syndroms wird
für jeden Datenbitbereich $B_j$(j=0...y-2) getrennt vorgenommen. Jedem Datenbitbereich $B_j$ sind ein erster Festwertspeicher $ROM_{j1}$ und ein zweiter Festwertspeicher $ROM_{j2}$ zugeordnet. Mit Hilfe der Festwertspeicher erfolgt die Umrechnung der in Koeffizientendarstellung verschlüsselten
Teilsyndrome $S_h$ und $S_1$ in die Exponentendarstellung, wobei die Teilsyndrome die Adressen bilden und der jeweils
adressierte Speicherplatz den zugehörigen Exponenten in
binärer Verschlüsselung enthält. Wie schon im Zusammenhang
mit der Betrachtung der Teilmatrizen $H_{(k-jb,b)}$ erwähnt
wurde, umfaßt das Teilsyndrom $S_h$ jeweils b Syndrombits und
zwar die Bits $s_{jb}$ bis $s_{(j+1)b-1}$, die damit für jeden Datenbitbereich verschieden sind. Dies ist auch leicht einzusehen, da bereits im zweiten Datenbitbereich $B_1$ eine
0-Matrix mit b Zeilen auftritt, die von gegebenenfalls
in diesem Bereich entstandenen Fehler nicht beeinflußt
wird.

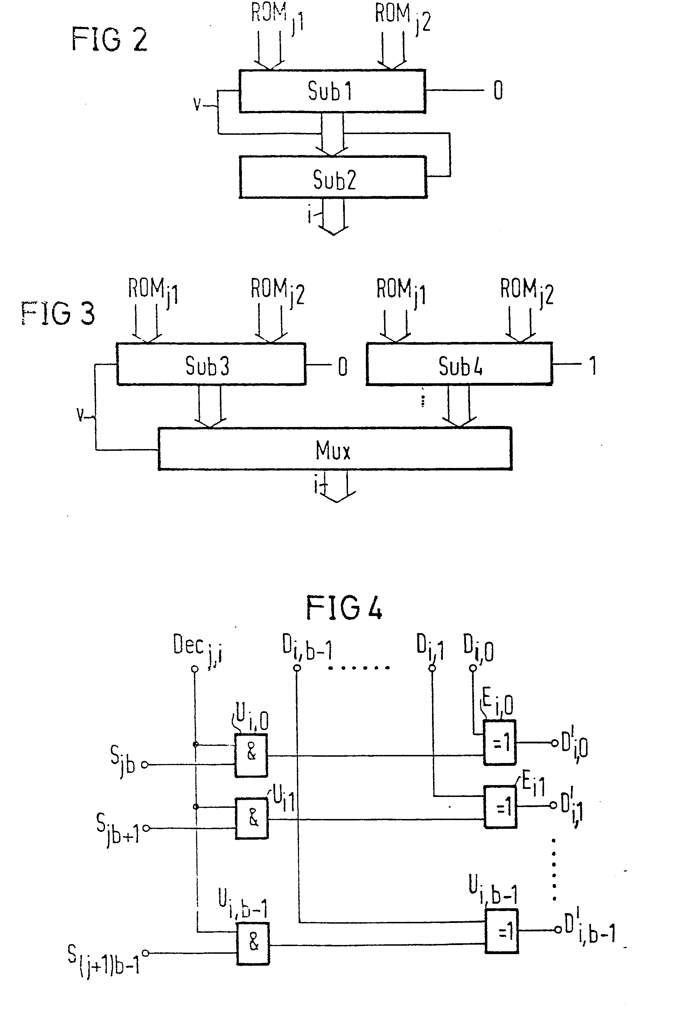

Mit der Variation des Teilsyndroms $S_h$ verändert sich auch
das Teilsyndrom $S_1$. Es besteht aus den k-(j+1)b Syndrombits $s_{(j+1)b}$ bis $s_{k-1}$ und wird damit von Bereich zu Bereich kürzer. Entsprechend der Abhängigkeit der Teilsyndrome vom Datenbitbereich werden die Teilsyndrome im folgenden mit $S_{jh}$ und $S_{jl}$ bezeichnet. Die aus jeweils zwei Festwertspeichern eines Datenbitbereichs gelesenen Informationen, die Potenzen in Form einer Binärzahl mit $k-(j+1)$ b Stellen darstellen, werden in je eine Subtrahiereinrichtung $Sub_j$ eingegeben, die eine Subtraktion modulo $2^{rj}-1$ durchführt. Die Figuren 2 und 3 zeigen zwei mögliche Ausführungen für eine Subtrahiereinrichtung $Sub_j$ in Fig. 1. In der ersten Ausführungsform nach Fig. 2 wird ein bei der Subtraktion im ersten Subtrahierer Sub1 entstehendes negatives Vorzeichen v mit dem logischen Wert 1 auf den Vorzeicheneingang des zweiten Subtrahierers Sub2 übertragen, der dann von der ersten Differenz nochmals eine 1 abzieht.

Beim zweiten Ausführungsbeispiel nach Fig. 3 sind zwei Subtrahierer Sub3 und Sub4 vorgesehen, deren entsprechende Eingänge parallel geschaltet sind. Der Vorzeicheneingang des rechten Subtrahierers Sub4 ist auf logisch 1 festgehalten, so daß sein Ergebnis stets um 1 niedriger ist als das Ergebnis des rechten Subtrahierers Sub3. Ein Multiplexer Mux zur wahlweisen Durchschaltung des Ergebnisses eines der beiden Subtrahierer wird durch das Vorzeichensignal des linken Subtrahierers Sub3 gesteuert. Bei einem negativen Vorzeichen wird der Ausgang des rechten Subtrahierers Sub4 durchgeschaltet.

Als Subtrahierer können handelsübliche arithmetische Subtrahierer verwendet werden. Zwar ist die Ausführungsform nach Fig. 3 aufwendiger als die andere Ausführung nach Fig. 2, aber auch schneller, da ein Multiplexer im allgemeinen eine wesentlich kürzere Signallaufzeit als ein Subtrahierer aufweist.

Die von den Subtrahiereinrichtungen $Sub_j$ der verschiedenen Datenbitbereiche $B_j$ gebildeten Differenzen werden an Decoder $Dec_j$ weitergeleitet, die aus binär verschlüsselten Werten für die Potenzen i Signale ableiten, welche die fehlerhaften Bytes bezeichnen und im folgenden Bytesignale genannt werden. Alle Decoder $Dec_j$ besitzen indessen noch einen zusätzlichen Eingang En für ein Freigabesignal, das die Ausgänge freigibt oder sperrt. Es sei zunächst nur festgehalten, daß die Decoder nur freigegeben werden, wenn ein Syndrom von Null verschieden ist und keine Prüfbitfehler vorliegen. Als Beispiel für die in Fig. 1 nicht enthaltenen Korrekturnetzwerke ist in Fig. 4 ein Korrekturnetzwerk für das Byte i im Datenbitbereich $B_j$ dargestellt. Das entsprechende Bytesignal vom Ausgang i des Decoders Decj im Bereich $B_j$ wird parallel b UND-Gliedern $U_{i,0}$ bis $U_{i,b-1}$ zugeführt. An den zweiten Eingängen der UND-Glieder liegen die zum Teilsyndrom $S_h$ gehörenden Syndrombits $s_{jb}$ bis $s_{(j+1)b-1}$. Die Ausgänge aller UND-Glieder sind mit den ersten Eingängen von EXKLUSIV-ODER-Gliedern $E_{i,0}$ bis $E_{i,b-1}$ verbunden. An den anderen Eingängen der EXKLUSIV-ODER-Glieder liegen die Datenbits $D_{i,0}$ bis $D_{i,b-1}$ des gegebenenfalls gefälschten Bytes an. An den Ausgängen der EXKLUSIV-ODER-Glieder stehen die korrigierten Datenbits $D'_{i,0}$ bis $D'_{i,b-1}$ zur Verfügung. Ein solches Korrekturnetzwerk ist für jedes Datenbyte vorhanden.

Ein von Null verschiedenes Syndrom kann auch durch die Fälschung von Prüfbits verursacht sein. In einem solchen Fall wäre es nicht zweckmäßig, einem Korrekturvorgang, der Zeit beansprucht, einzuleiten, um dann zuletzt die Korrektur selbst doch nicht auszuführen, weil sie nicht sinnvoll wäre. Vielmehr besteht Interesse daran, eine Fälschung von Prüfbits als solche möglichst rasch zu erkennen und die Daten umgehend freizugeben.

Zu diesem Zweck wird aus dem Festwertspeicher $ROM_{12}$ ein zusätzliches Bit $CF_{-1}$ ausgelesen, das immer dann 1 ist, wenn alle die zugehörige Adresse bildenden Syndrombits $s_b$ bis $s_{k-1}$ Null sind, ausgenommen jedoch mindestens ein Bit aus der ein Byte umfassenden Gruppe $s_{jb}$ bis $s_{(j+1)b-1}$. Das zusätzliche Bit $CF_{-1}$ aus dem Festwertspeicher $ROM_{12}$ liegt an einem Eingang eines UND-Glieds 6, dessen zweiter Eingang mit dem das Signal $CF_0$ führenden Ausgang des NOR-Glieds 5a des Nulldetektors 5 verbunden ist. Der genannte Ausgang ist auch an einen invertierenden Eingang eines weiteren UND-Glieds 7 angeschlossen. Am zweiten Eingang des UND-Glieds 7 liegt das vom NOR-Glied 5b gelieferte Signal $KF_1$. Die Ausgänge der UND-Glieder 8 und 9 werden durch ein ODER-Glied 8 zu einem Signal CF zusammengefaßt, dessen logischer Wert 1 besagt, daß ein oder mehrere Prüfbitfehler, jedoch keine Datenbitfehler vorliegen. Es erfolgt die sofortige Datenfreigabe.

Zur Ableitung der schon erwähnten Freigabesignale für die Decoder $Dec_j$ der einzelnen Datenbitbereiche $B_j$ werden zusätzliche Signale $CF_j$ analog zu dem Signal $CF_0$ gebildet, in dem jeweils die Syndrombits $s_{jb}$ bis $s_{(j+1)b-1}$ mit $j=1...y-2$ in einem jedem Datenbitbereich $B_j$ mit Ausnahme des ersten und letzten zugeordneten NOR-Glied** im Datenbitbereich $B_j$. Dem NOR-Glied 9 werden die gleichen b Bits zugeführt, die auch als Adresse für den Festwertspeicher $ROM_{j1}$ dienen.

Die Freigabesignale $En_j$ für die Decoder $Dec_j$ in den einzelnen Datenbitbereichen $B_j$ ergeben sich aus folgenden logischen Beziehungen:

$$En_0 = \overline{KF_1 + CF_0}$$
$$En_1 = \overline{KF_1} \cdot \overline{CF}_{-1} \cdot CF_0$$
$$En_2 = \overline{KF_1} \cdot \overline{CF}_{-1} \cdot CF_0 \cdot CF_1$$
$$En_j = \overline{KF_1} \cdot \overline{CF}_{-1} \cdot CF_0 \cdot CF_1 \cdot ... CF_{j-1}$$

** verknüpft werden. Gemäß Fig. 1 dient hierzu das NOR-Glied 9

Zur Realisierung der angegebenen logischen Verknüpfungen ist im Datenbitbereich $B_0$ ein NOR-Glied 10 vorgesehen. Der in Fig. 1 nicht dargestellte Datenbitbereich $B_1$ müßte dann ein UND-Glied mit zwei invertierenden Eingängen und einem Normaleingang enthalten. Es ist leicht zu sehen, daß das Signal $En_j$ ($j \geq 1$) sich aus der Beziehung $En_j = En_{j-1} \cdot CF_{j-1}$ ergibt. Indes wäre die Herleitung der Freigabesignale unter Verwendung des Freigabesignals des jeweils vorhergehenden Datenbitbereichs nicht zweckmäßig, da sich die Signallaufzeiten in unerwünschter Weise summieren. Es ist daher besser, den geringen Mehraufwand in Kauf zu nehmen und die genannten Signale in jedem Datenbitbereich unmittelbar gemäß einer UND-Funktion zu verknüpfen. Dies geschieht im Datenbitbereich $B_j$ durch das UND-Glied 11.

Nachstehend wird der besseren Übersicht wegen ein konkretes Ausführungsbeispiel behandelt, dem die folgenden Werte zugrundeliegen:

Bytelänge b=2 Bits

Anzahl der Prüfbits k=6

Anzahl der Datenbits m=36

Codelänge n=42 Bits.

Aus k=6 und b=2 folgt y=3, z=0 und j=0,1.

Daraus ergibt sich weiter für

j=0 $r_0 = k-(j+1)b = 4$

   Bereichslänge 30 Bits.

j=1 $r_1 = 2$

   Bereichslänge 6 Bits.

Daraus folgt ferner, daß die Elemente der Code-Matrix für den Bereich $B_0$ dem Galoisfeld $GF(2^4)$ zu entnehmen sind. Das erzeugende irreduzible Polynom für das Galoisfeld $GF(2^4)$ ist vom Grad 4 und besitzt die Koeffizientenfolge 1 0 0 1 1. (Vergleiche W. Peterson, "Error-Correcting Codes", The M. I. T. Press, Cambridge, Massachusetts 1965,

Seiten 251 bis 254). Entsprechend ist das erzeugende Polynom für das Galoisfeld $GF(2^2)$ vom Grad 2 und besitzt die Koeffizientenfolge 1 1 1. Die folgenden Tabellen stellen die betreffenden Galoisfelder dar. Dabei steht jeweils in der ersten Spalte der Exponent i von $\alpha^i$ (Potenzdarstellung). Die zweite Spalte gibt die Koeffizientenfolge der Polynomdarstellung der $\alpha^i$ an. (l.c. Seite 100, jedoch mit vertauschter Koeffizientenreihenfolge).

$GF(2^2)$, erzeug. Polynom 111

| i | $\alpha^i$ |
|---|---|
| 0 | 01 |
| 1 | 10 |
| 2 | 11 |

$GF(2^4)$, erzeug. Polynom 10011

| i | $\alpha^i$ | i | $\alpha^i$ |
|---|---|---|---|
| 0 | 0001 | 8 | 0101 |
| 1 | 0010 | 9 | 1010 |
| 2 | 0100 | 10 | 0111 |
| 3 | 1000 | 11 | 1110 |
| 4 | 0011 | 12 | 1111 |
| 5 | 0110 | 13 | 1101 |
| 6 | 1100 | | |
| 7 | 1011 | | |

Es können nunmehr die Teilmatrizen und damit auch die Gesamtmatrix $H_s$ aufgestellt werden. Aus der allgemeinen Struktur einer Teilmatrix folgt, daß für die ersten b=2 Zeilen jeder Teilmatrix aus dem betreffenden Galoisfeld der Inhalt der beiden ersten Spalten von rechts nach links und mit i=0 beginnend übernommen wird. Man sieht sofort, daß sich daraus für beide Teilmatrizen 2·2-Einheitsmatrizen ergeben (allgemein b·b-Einheitsmatrizen für alle Teilmatrizen).

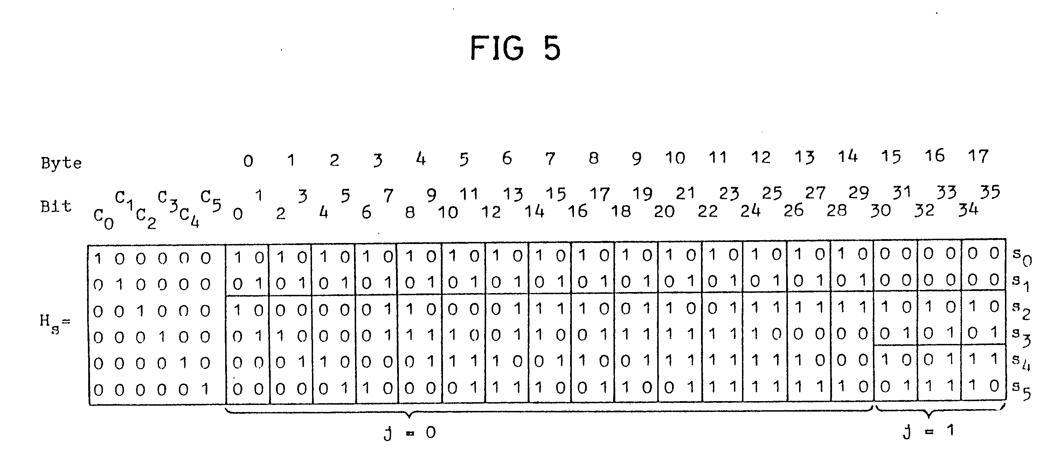

In analoger Weise werden die Inhalte der restlichen k-b=4 bzw. 3-z b= z Zeilen der Teilmatrizen gewonnen. Entsprechend der allgemeinen Struktur der Teilmatrizen werden in die Spalten aufsteigender Bit- bzw. Byte-Nummern der Teilmatrizen byteweise die Koeffizienten aus jeweils zwei Zeilen des zugehörigen Galoisfeldes übernommen, wobei die Richtung von oben nach unten in der Teilmatrix der Richtung von rechts nach links im Galoisfeld entspricht. Bei der Aufstellung der Gesamtmatrix ist zu beachten, daß für $j=1$ die beiden ersten Zeilen durch eine C-Matrix belegt sind. Die Figur 5 zeigt die $H_s$-Matrix des GMC $(42,36)^2$-Codes.

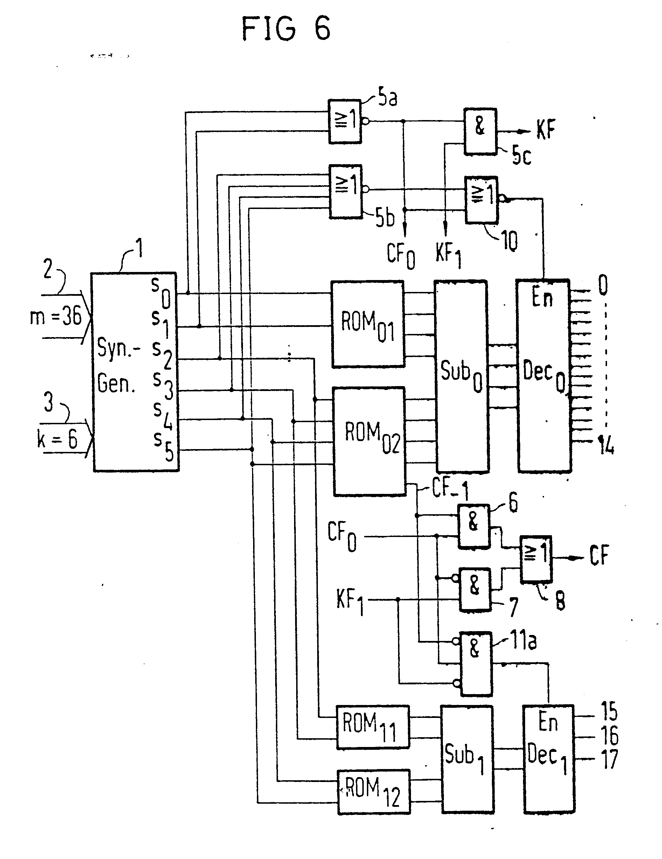

In Fig. 6 ist eine Korrekturschaltung dargestellt, die auf den GMC $(42,36)^2$-Code, d. h. auf die charakteristischen Werte $b=2, k=6, n=42, m=36$ abgestellt ist. Die Schaltungsanordnung gleicht in ihren wesentlichen Bestandteilen der Schaltungsanordnung nach Fig. 1, weshalb übereinstimmende Elemente auch gleich bezeichnet sind.

Über die Leitungsbündel 2 und 3 liegen am Syndromgenerator 1 36 Datenbits und 6 Prüfbits $C_0$ bis $C_5$ an. Der Syndromgenerator 1 erzeugt daraus Syndrome mit den Syndrombits $s_0$ bis $s_5$. Wegen $b=2$ bilden die Syndrombits $s_0$ und $s_1$ das Teilsyndrom $S_h$ und die Syndrombits $s_2$ bis $s_5$ das Teilsyndrom $S_1$ für den Datenbereich $B_0$. Im Datenbitbereich $B_1$ besteht das Teilsyndrom $S_h$ aus den Syndrombits $s_2$ und $s_3$ und das Teilsyndrom $S_1$ aus den Syndrombits $s_4$ und $s_5$. Mit Hilfe der NOR-Glieder 5a und 5b werden die Signale $CF_0$ aus den Syndrombits $s_0$ und $s_1$ und $KF_1$ aus den Syndrombits $s_2$ bis $s_5$ abgeleitet. Das Signal KF nimmt den logischen Wert 1 an und besagt damit, daß kein Fehler aufgetreten ist, wenn die Signale $CF_0$ und $KF_1$ an den Eingängen des UND-Glieds 5c ebenfalls 1 sind.

Als Adressen für den ersten Festwertspeicher $ROM_{01}$ im Datenbitbereich $B_0$ dienen die Syndrombits $s_0$ und $s_1$. Der zweite Festwertspeicher $ROM_{02}$ wird durch die Syndrombits $s_2$ bis $s_5$ adressiert. Zur Adressierung der beiden Festwertspeicher $ROM_{11}$ und $ROM_{12}$ im Datenbitbereich $B_1$ werden die Syndrombits $s_2$ und $s_3$ bzw. $s_4$ und $s_5$ benützt. Die Inhalte der Festwertspeicher, die durch die Werte der Exponenten i in binärer Codierung gegeben sind, sind unter allen jeweils möglichen Kombinationen der Adress-

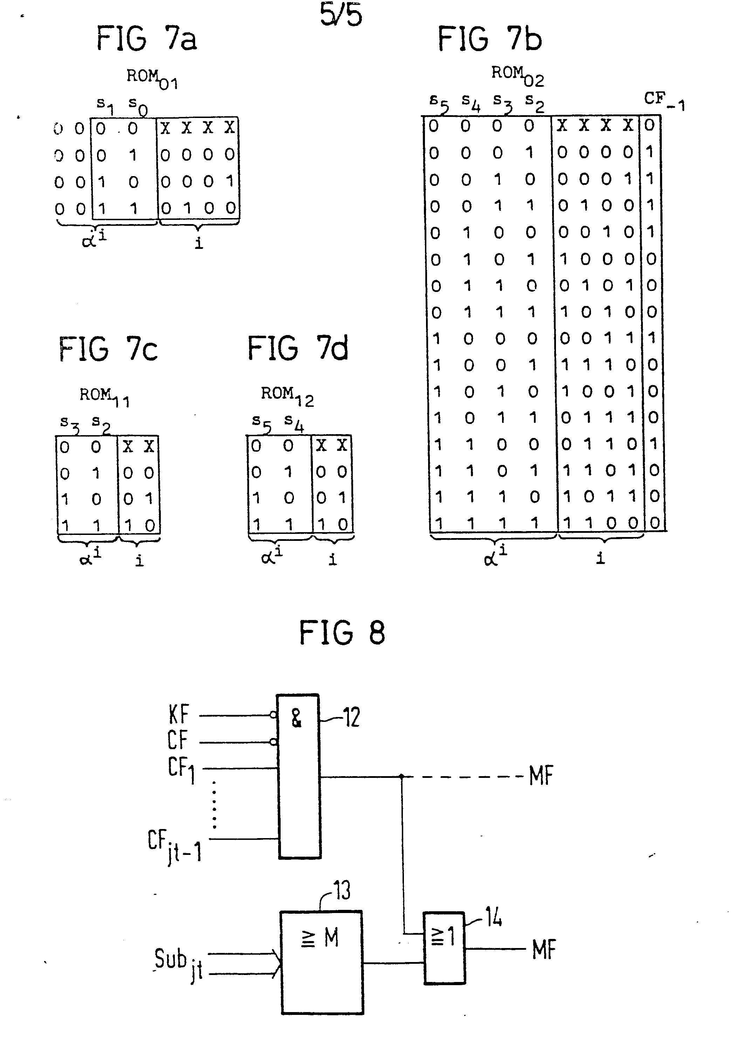

bits bzw. Syndrombits bzw. Koeffizienten $\alpha^i$ in den Figuren 7a bis 7d dargestellt. Die Belegung der Speicherplätze unter den Adressen 00 bzw. 0000 ist beliebig, da diese Adressen für die Auswertung nicht benötigt werden.

Der Festwertspeicher $ROM_{02}$ enthält noch das zusätzliche Bit $CF_{-1}$, das durch die logische Beziehung $CF_{-1} = \overline{s_2 + s_3} (s_4 + s_5) + \overline{s_4 + s_5} (s_2 + s_3)$ bestimmt ist.

Die Subtrahiereinrichtungen $Sub_0$ und $Sub_1'$ in den beiden Datenbitbereichen entsprechen in ihrem Aufbau völlig den anhand der Figur 2 bzw. 3 beschriebenen Subtrahiereinrichtungen $Sub_j$ nach Fig. 1. Die Subtraktionen erfolgen modulo-15 bzw. modulo-3.

Weiterhin gleichen die Decoder $Dec_0$ und $Dec_1$ denen in der Anordnung nach Fig. 1. Die Freigabesignale $En_0$ und $En_1$ werden ebenfalls in gleicher Weise gewonnen und zwar $En_0 = \overline{KF_1 + CF_0}$ durch das NOR-Glied 10 und $En_1 = \overline{KF_1} \cdot \overline{CF_{-1}} \cdot CF_0$ durch das UND-Glied 11a mit zwei invertierenden Eingängen und einem Normaleingang. Schließlich entspricht auch die Einrichtung zur Bildung des Signals CF, das einen Prüfbitfehler anzeigt, mit den Verknüpfungsgliedern 6, 7 und 8 genau jener in Figur 1.

Wie schon erwähnt wurde, sind die GMC-Codes, wenn sämtliche Datenbytes tatsächlich benutzt werden, sogenannte perfekte Codes, d. h. es stehen keine zusätzlichen Syndrome zur Mehrfachfehlererkennung zur Verfügung. Sobald aber nur ein Teil der Datenbytes verwendet wird, sind einige Syndrome zur Mehrfachfehlererkennung frei. Das wird in der Praxis häufig der Fall sein.

Werden nur die Bytes 0 bis $i_t$ benutzt, dann sind auch nur dafür Korrektureinrichtungen nötig. Alle Syndrome, die gemäß der $H_s$-Matrix den restlichen Bytes $i_t + 1$ bis $\frac{m}{b}$ zugeordnet sind, deuten nur auf Mehrfachfehler hin. Für das folgende werden zwei Fälle unterschieden, die verschiedene Auswirkungen auf die Schaltungsanordnung nach Fig. 1 haben.

a) Die Grenze zwischen benutzten und unbenutzten Bytes fällt mit der Grenze zwischen den Datenbitbereichen $B_{jt-1}$ und $B_{jt}$ zusammen, d. h. das Byte $i_t$ liegt noch im Bereich $B_{jt-1}$, während das Byte $i_t+1$ schon im Bereich $B_{jt}$ steht. Es entfallen dann alle Decodiereinrichtungen, wie Festwertspeicher, Subtrahierer und Decodierer einschließlich der Anordnung zur Erzeugung der Freigabesignale sowie die Korrekturnetzwerke in allen Bereichen $B_{jt}$ bis $B_{y-2}$. Im Bereich $B_{jt}$ wird dafür ein UND-Glied mit zwei invertierenden Eingängen vorgesehen, an dessen Ausgang ein Signal MF anliegt, dessen logischer Wert 1 einen Mehrfachfehler bezeichnet. Es gilt folgende Beziehung:

$$MF = \overline{KF} \cdot \overline{CF} \cdot CF_1 \cdot CF_2 \ldots CF_{j1-1}$$

b) Die Grenze zwischen benutzten und unbenutzten Bytes liegt innerhalb eines Datenbitbereichs $B_{jt}$. Es entfallen alle Decodiereinrichtungen und Korrekturnetzwerke für die folgenden Datenbitbereiche $B_{jt+1}$ bis $B_{y-2}$. Zu dem UND-Glied 12 nach a) tritt noch eine Vergleichseinrichtung 13, die feststellt, ob der von der Subtrahiereinrichtung $Sub_{jt}$ des Bereichs $B_{jt}$ in Form einer Binärzahl gelieferte Exponent i $i_t$ ist. Trifft das zu, dann gibt die Vergleichseinrichtung 13 ein Signal mit dem logischen Wert 1 ab, das nun in dem ODER-Glied 14 mit dem Ausgangssignal des UND-Glieds 12 zu dem Signal MF verknüpft wird. Die zusätzlichen Schaltungseinrichtungen sind in Fig. 8 dargestellt.

8 Figuren

5 Patentansprüche

Liste der Bezugszeichen                    VPA 78 P 2080 EUR

1         Syndromgenerator
2         Leitungsbündel für Datenbits
3         Leitungsbündel für k Prüfbits
4         Leitungsbündel für k Syndrombits
5         erster Nulldetektor
5a,5b,9,10   NOR-Glied
5c,6,7,11,11a,12 UND-Glied
8,14      ODER-Glied
13        Vergleichseinrichtung
$ROM_{j1}$    erster Festwertspeicher
$ROM_{j2}$    zweiter Festwertspeicher
$B_j$     Datenbitbereich
$Sub_j$   Subtrahiereinrichtung
Sub1-Sub4 arithmetischer Subtrahierer
Mux       Multiplexer
$Dec_j$   Decoder
$U_{i,0}-U_{i,b-1}$   UND-Glied
$E_{i,0}-E_{i,b-1}$   EXKLUSIV-ODER-Glied

Patentansprüche

1. Schaltungsanordnung zur Korrektur von Fehlern in einem Byte mit b Bits innerhalb eines aus mehreren Bytes bestehenden Datenblocks, unter Verwendung eines GMC-Codes mit $k=yb+z$ Prüfbits ($y \geq 2$, $0 \leq z < b$, alle Größen ganzzahlig), dessen systematische $H_s$-Matrix aus einer $k \cdot k$ Einheitsmatrix $E_k$ und $y-1$ Datenbitbereichen $B_j$ ($j=0 \ldots y-2$) besteht, wobei die Elemente jedes Datenbitbereichs $B_j$ dem Galoisfeld $GF(2^{k-(j+1)b})$ entnommen sind und die Koeffizienten $\alpha^i$ eines erzeugenden, irreduziblen Polynoms darstellen, mit einem Nulldetektor zur Feststellung des Wertes Null eines durch Vergleich von Prüfbits gleicher Wertigkeit gewonnenen Syndroms, mit Fehlerortdecodern zur Decodierung von Fehlerortinformationen und zur Bildung von Fehlerortsignalen und mit durch die Fehlerortsignale gesteuerten Korrekturnetzwerken, d a d u r c h   g e k e n n - z e i c h n e t , daß jedem Datenbitbereich $B_j$ ein durch die Syndrombits $s_{jb}$ bis $s_{(j+1)b-1}$ eines von Null verschiedenen Syndroms adressierbarer, erster Festwertspeicher (ROM$_{j1}$) und ein durch die Syndrombits $s_{(j+1)b}$ bis $s_{k-1}$ eines von Null verschiedenen Syndroms adressierbarer, zweiter Festwertspeicher (ROM$_{j2}$) zugeordnet sind, daß die Festwertspeicher (ROM$_{j1}$, ROM$_{j2}$) in entsprechender Zuordnung zu den Adressen die Potenzen $i$ der Koeffizienten $\alpha^i$ in binärer Darstellung enthalten, daß für jeden Datenbitbereich $B_j$ eine Subtrahiereinrichtung Sub$_j$ zur Bildung der Differenz modulo $2^{k-(j+1)b}-1$ aus den jeweils ausgelesenen Inhalten der dazugehörigen ersten und zweiten Festwertspeicher (ROM$_{j1}$, ROM$_{j2}$) vorgesehen ist, welche Differenz den Fehlerort des gegebenenfalls gefälschten Bytes (i) innerhalb des Datenbitbereichs $B_j$ in Form einer Binärzahl mit $k-(j+1)b$ Stellen angibt und einem Fehlerortdecoder (Dec$_j$) zugeführt wird, und daß die Syndrombits $s_{jb}$ bis $s_{(j+1)b-1}$ mit den Ausgangssignalen des Fehlerortdecoders (Dec$_j$) durch UND-Glieder verknüpft sind, deren Ausgangssignale die Korrekturnetzwerke steuern.

2. Schaltungsanordnung nach Anspruch 1, d a d u r c h
g e k e n n z e i c h n e t, daß der Nulldetektor (5)
zwei NOR-Glieder (5a und 5b) zur Bildung eines ersten
Signals $CF_0$ durch NOR-Verknüpfung der b ersten Syndrombits $s_0$ bis $s_{b-1}$ und zur Bildung eines zweiten Signals
$KF_1$ durch NOR-Verknüpfung der restlichen Syndrombits $s_b$
bis $s_{k-1}$ und ein UND-Glied (5c) zur Verknüpfung der Signale $CF_0$ und $KF_1$ enthält, daß Einrichtungen vorgesehen
sind zur Erzeugung eines weiteren Signals $CF_{-1}$, das dann
und nur dann den logischen Wert 1 annimmt, wenn bei einer
byteweisen Gruppierung der Syndrombits $s_b$ bis $s_{k-1}$ alle
Syndrombits gleich Null sind mit Ausnahme mindestens eines
Syndrombits in nur einem Byte, daß ferner eine aus zwei
UND-Gliedern (8,9) und einem ODER-Glied (10) bestehende
Anordnung zur Bildung eines Signals CF gemäß der Beziehung
$CF = CF_0 \cdot CF_{-1} + \overline{CF_0} \cdot KF_1$ vorhanden ist, wobei der Wert 1 dieses Signals die Datenfreigabe bewirkt und das Vorhandensein von Prüfbitfehlern ohne gleichzeitiges Auftreten von
Datenbitfehlern kennzeichnet.

3. Schaltungsanordnung nach Anspruch 2, d a d u r c h
g e k e n n z e i c h n e t, daß zur Erzeugung des
Signals $CF_{-1}$ in dem zweiten Festwertspeicher ($ROM_{02}$)
unter allen Adressen ein zusätzliches Bit mit dem entsprechenden Binärwert gespeichert ist.

4. Schaltungsanordnung nach Anspruch 1 oder 3, d a -
d u r c h   g e k e n n z e i c h n e t, daß die
Subtrahiereinrichtung ($Sub_j$) aus der Serienschaltung eines ersten und zweiten arithmetischen Subtrahierers besteht, wobei durch den ersten Subtrahierer die aus dem
ersten Festwertspeicher ($ROM_{j1}$) stammende Binärzahl von
der aus dem zweiten Festwertspeicher ($ROM_{j2}$) stammenden
Binärzahl abgezogen wird und wobei im Fall einer negativen ersten Differenz diese im zweiten Subtrahierer nochmals um 1 vermindert wird.

5. Schaltungsanordnung nach Anspruch 1 oder 3, d a -
d u r c h   g e k e n n z e i c h n e t, daß die Subtrahiereinrichtung (Sub$_j$) einen ersten und zweiten arithmetischen Subtrahierer enthält, deren einander entsprechende
Eingänge parallel geschaltet sind und deren Ausgänge alternativ über einen Multiplexer durchgeschaltet werden, wobei durch den ersten Subtrahierer die aus dem ersten Festwertspeicher (ROM$_{j1}$) stammende Binärzahl von der aus dem
zweiten Festwertspeicher (ROM$_{j2}$) stammenden Binärzahl abgezogen wird und durch den zweiten Subtrahierer die entsprechende, jedoch stets um 1 verminderte Differenz gebildet wird und wobei im Fall einer negativen Differenz
im ersten Subtrahierer der Ausgang des zweiten Subtrahierers durchgeschaltet wird.

FIG 1

0012828

1/5

FIG 2

$ROM_{j1}$   $ROM_{j2}$

v ——| Sub1 |—— 0

| Sub2 |

i

FIG 3

$ROM_{j1}$   $ROM_{j2}$        $ROM_{j1}$   $ROM_{j2}$

| Sub3 |—— 0        | Sub4 |—— 1

v

| Mux |

i

FIG 4

$Dec_{j,i}$        $D_{i,b-1}$  ......  $D_{i,1}$   $D_{i,0}$

$U_{i,0}$        $E_{i,0}$

$S_{jb}$ ——o        &        =1 ——o $D'_{i,0}$

$U_{i1}$        $E_{i1}$

$S_{jb+1}$ ——o        &        =1 ——o $D'_{i,1}$

$U_{i,b-1}$        $U_{i,b-1}$

$S_{(j+1)b-1}$ ——o        &        =1 ——o $D'_{i,b-1}$

# FIG 5

3/5

Byte      0  1  2  3  4  5  6  7  8  9  10  11  12  13  14  15  16  17

Bit  $c_0$ $c_1$ $c_2$ $c_3$ $c_4$ $c_5$  0 1 2 3 4 5 6 7 8 9 10 11 12 13 14 15 16 17 18 19 20 21 22 23 24 25 26 27 28 29 30 31 32 33 34 35

$H_s =$

```
1 0 0 0 0 0 | 1 0|1 0|1 0|1 0|1 0|1 0|1 0|1 0|1 0|1 0|1 0|1 0|1 0|1 0|0 0|0 0|0 0  s0
0 1 0 0 0 0 | 0 1|0 1|0 1|0 1|0 1|0 1|0 1|0 1|0 1|0 1|0 1|0 1|0 1|0 1|0 0|0 0|0 0  s1
0 0 1 0 0 0 | 1 0|0 0|0 0|0 1|1 0|0 0|0 1|1 1|1 0|0 1|1 0|0 1|1 1|1 1|1 0|1 0|1 0  s2
0 0 0 1 0 0 | 0 1|1 0|0 0|0 1|1 1|1 0|0 1|1 0|0 1|1 1|1 1|1 1|1 0|0 0|0 1|0 1|0 1  s3
0 0 0 0 1 0 | 0 0|0 1|1 0|0 0|0 1|1 1|1 0|0 1|1 0|0 1|1 1|1 1|1 1|1 0|1 0|0 1|1 1  s4
0 0 0 0 0 1 | 0 0|0 0|0 1|1 0|0 0|0 1|1 1|1 0|0 1|1 0|0 1|1 1|1 1|1 1|0 1|1 1|1 0  s5
                           j = 0                                          j = 1
```

0012828

FIG 6

## FIG 7a

ROM$_{01}$

| | $s_1$ | $s_0$ | | | | |
|---|---|---|---|---|---|---|
| 0 0 | 0 | 0 | X | X | X | X |
| 0 0 | 0 | 1 | 0 | 0 | 0 | 0 |
| 0 0 | 1 | 0 | 0 | 0 | 0 | 1 |
| 0 0 | 1 | 1 | 0 | 1 | 0 | 0 |

$\underbrace{\qquad}_{\alpha^i} \qquad \underbrace{\qquad}_{i}$

## FIG 7b

ROM$_{02}$

| $s_5$ | $s_4$ | $s_3$ | $s_2$ | | | | | $CF_{-1}$ |
|---|---|---|---|---|---|---|---|---|
| 0 | 0 | 0 | 0 | X | X | X | X | 0 |
| 0 | 0 | 0 | 1 | 0 | 0 | 0 | 0 | 1 |
| 0 | 0 | 1 | 0 | 0 | 0 | 0 | 1 | 1 |
| 0 | 0 | 1 | 1 | 0 | 1 | 0 | 0 | 1 |
| 0 | 1 | 0 | 0 | 0 | 0 | 1 | 0 | 1 |
| 0 | 1 | 0 | 1 | 1 | 0 | 0 | 0 | 0 |
| 0 | 1 | 1 | 0 | 0 | 1 | 0 | 1 | 0 |
| 0 | 1 | 1 | 1 | 1 | 0 | 1 | 0 | 0 |
| 1 | 0 | 0 | 0 | 0 | 0 | 1 | 1 | 1 |
| 1 | 0 | 0 | 1 | 1 | 1 | 1 | 0 | 0 |
| 1 | 0 | 1 | 0 | 1 | 0 | 0 | 1 | 0 |
| 1 | 0 | 1 | 1 | 0 | 1 | 1 | 1 | 0 |
| 1 | 1 | 0 | 0 | 0 | 1 | 1 | 0 | 1 |
| 1 | 1 | 0 | 1 | 1 | 1 | 0 | 1 | 0 |
| 1 | 1 | 1 | 0 | 1 | 0 | 1 | 1 | 0 |
| 1 | 1 | 1 | 1 | 1 | 1 | 0 | 0 | 0 |

$\underbrace{\qquad}_{\alpha^i} \qquad \underbrace{\qquad}_{i}$

## FIG 7c

ROM$_{11}$

| $s_3$ | $s_2$ | | |
|---|---|---|---|
| 0 | 0 | X | X |
| 0 | 1 | 0 | 0 |
| 1 | 0 | 0 | 1 |
| 1 | 1 | 1 | 0 |

$\underbrace{\qquad}_{\alpha^i} \quad \underbrace{\qquad}_{i}$

## FIG 7d

ROM$_{12}$

| $s_5$ | $s_4$ | | |
|---|---|---|---|
| 0 | 0 | X | X |
| 0 | 1 | 0 | 0 |
| 1 | 0 | 0 | 1 |
| 1 | 1 | 1 | 0 |

$\underbrace{\qquad}_{\alpha^i} \quad \underbrace{\qquad}_{i}$

## FIG 8

0012828

Nummer der Anmeldung

**Europäisches Patentamt**

# EUROPÄISCHER RECHERCHENBERICHT

EP 79 10 4461

| | EINSCHLÄGIGE DOKUMENTE | | KLASSIFIKATION DER ANMELDUNG (Int Cl. ³) |
|---|---|---|---|
| Kategorie | Kennzeichnung des Dokuments mit Angabe, soweit erforderlich, der maßgeblichen Teile | betrifft Anspruch | |
| A | <u>US - A - 3 745 526</u> (HONG) <br> * Zusammenfassung * <br><br> -- | 1 | G 06 F 11/10 |
| A | <u>US - A - 3 745 525</u> (HONG) <br> * Zusammenfassung * <br><br> -- | 1 | |
| A | IBM TECHNICAL DISCLOSURE BULLETIN, Band 18, Nr. 4, September 1975, Seiten 1062-1064. New York, YS PRICE: "81,64-Byte Error Correction Code". <br><br> * Seite 1063, Abschnitt 2 bis letzter Abschnitt * <br><br> ---- | 1 | **RECHERCHIERTE SACHGEBIETE (Int. Cl. ³)** <br><br> G 06 F 11/10 <br> H 04 L 1/10 |

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort <br> Den Haag | Abschlußdatum der Recherche <br> 21-03-1980 | Prüfer <br> WEBER R. |
|---|---|---|

EPA form 1503.1   06.78